# FASCICULE DE BREVET EUROPEEN

(11) **EP 4 268 282 B1**
(45) Date de publication et mention de la délivrance du brevet: **12.03.2025**
(21) Numéro de dépôt: 21844247.3
(22) Date de dépôt: 21.12.2021
(51) Int. Cl.: H01L 27/146

(54) **INTEGRATION D'UN CIRCUIT DE DETECTION A BASE DE RESONATEURS OPTIQUES SUR UN CIRCUIT DE LECTURE D'UN IMAGEUR**
INTEGRATION EINER DETEKTIONSSCHALTUNG AUF DER BASIS VON OPTISCHEN RESONATOREN AUF EINER AUSLESESCHALTUNG EINES BILDAUFNEHMERS
INTEGRATION OF A DETECTION CIRCUIT BASED ON OPTICAL RESONATORS ON A READOUT CIRCUIT OF AN IMAGER

(30) Priorité: 23.12.2020 FR 2014016
(43) Date de publication de la demande: 01.11.2023
(73) Titulaire: THALES, 92190 Meudon (FR); Commissariat à l'Energie Atomique et aux Energies Alternatives, 75015 Paris (FR)
(72) Inventeur: DELGA, Alexandre, 91477 PALAISEAU CEDEX (FR); ESPIAU DE LAMAESTRE, Roch, 38000 GRENOBLE (FR)
(74) Mandataire: Atout PI Laplace
(86) Numéro de dépôt international: PCT/EP2021/087003
(87) Numéro de publication internationale: WO 2022/136378

(56) Documents cités:
- EP-A1- 3 410 486
- WO-A1-2019/180165
- US-A- 5 455 421
- US-A- 5 773 831

## Description

### Champ d'application

L'invention concerne les systèmes hybrides, c'est à dire constitués de deux parties distinctes assemblées par une couche d'assemblage, chaque partie étant réalisée dans un matériau différent. Ces systèmes peuvent être optiques, électroniques ou optoélectroniques en fonction des caractéristiques des parties assemblées. L'invention concerne particulièrement l'intégration d'une pluralité de résonateurs optiques de type métal-isolant-métal sur un circuit intégré de lecture d'un capteur d'image matriciel dans le domaine de l'infrarouge. L'imageur matriciel est composé d'une pluralité de pixels, et chaque pixel comprend un unique résonateur optique.

US 985 773 831 A, EP 3 410 486 A1, US 5 455 421 A et WO 2019/180165 A1 divulguent des dispositifs optoélectroniques selon l'art antérieur.

### Problème soulevé

Les systèmes hybrides permettent d'associer deux fonctionnalités réalisées dans des matériaux différents. Il s'agit par exemple :
- d'un détecteur, dans lequel la partie sensible est associée à un circuit de lecture permettant de récolter et traiter le signal à détecter,
- d'un afficheur, par exemple de type électroluminescent, dans lequel la partie émettrice est associée avec un circuit de génération de signaux électriques adaptés à l'émission,
- d'un circuit photonique, avec des émetteurs lasers associés à des couches de traitement des faisceaux émis (guidage, multiplexage/démultiplexage, amplification ...), la/les couches de traitement étant déposées sur un substrat silicium (« Photonic on Silicon »),
- d'un circuit électronique avec des transistors rapides ou de puissance associés à un système de contrôle.
Les deux premiers systèmes hybrides peuvent être qualifiés d'optoélectroniques, le troisième peut être purement optique ou optoélectronique, tandis que le quatrième est purement électronique.

Plus particulièrement, le domaine technique concerné est la réalisation de systèmes hybrides optoélectroniques, comprenant :
une partie optique basée sur au moins un élément photosensible permettant de générer des porteurs de charges électriques à partir de photons incidents (par exemple matrice de bolomètres, de photodiodes, ou de photoconducteurs) ;
et une partie électronique consistant en un circuit de lecture intégré sur un substrat semi-conducteur permettant de lire individuellement le signal de chaque pixel de la partie optique. Un pixel appartenant au système optoélectronique peut contenir un unique élément photosensible ou une pluralité d'éléments photosensibles connectés entre eux.

Il existe des technologies d'imageurs où la couche photosensible est constituée d'une première famille de matériaux semi-conducteurs et le circuit intégré de lecture est réalisé dans un substrat d'une seconde famille de matériaux semi-conducteurs différente de la première. Les photo-détecteurs sont réalisés via des matériaux semi-conducteurs de type III-V tel que l'arséniure de gallium, arséniure d'indium, nitrure de gallium, antimoniure de gallium, phosphure de bore. Les photo-détecteurs peuvent en outre être réalisés via des matériaux semi-conducteurs de type II-VI. Pour construire un système hybride, il est nécessaire d'assembler les photo-détecteurs et de les interconnecter avec le circuit de lecture intégré sur un substrat en silicium.

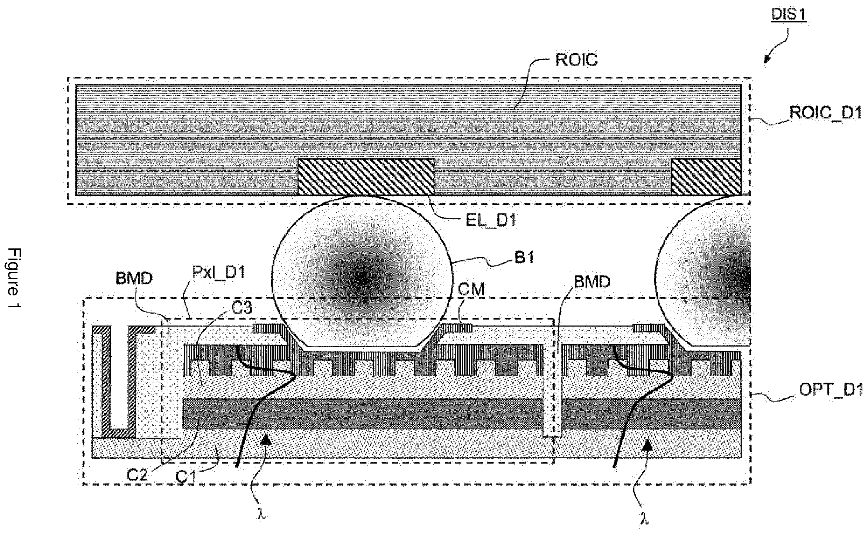

La figure 1 illustre une vue en coupe partielle d'un système hybride optoélectronique selon l'état de l'art ayant une partie optique comprenant un réseau de diffraction en métal à l'arrière de chaque pixel. Le dispositif optoélectronique Dis1 illustré sur la figure 1 est un imageur infrarouge à transport vertical. Il se compose d'une partie optique OPT_D1 comprenant au moins un pixel PxI_D1 et d'une partie électronique consistant en un circuit intégré de lecture ROIC_D1 comprenant au moins une électrode enterrée EL_D1.

Le circuit intégré de lecture ROIC_D1 est réalisé au moyen d'une pluralité de transistors et de couches minces en matériaux conducteurs, semi-conducteurs ou diélectriques selon la technologie CMOS (Complementary Metal-Oxide-Semiconductor) sur un substrat en silicium. Pour chaque pixel PxI_D1, une électrode enterrée EL_D1 est associée pour lire les signaux générés par les porteurs de charges photo générés par la structure photo détectrice d'un pixel PxI_D1.

Concernant la partie optique du dispositif, elle comprend une pluralité de couches C1 ,C2, C3 avec C1 et C3 deux couches conductrices obtenues par le dopage de type N+ d'un matériau semi-conducteur de type III-V (ou II-VI) et C2 une couche semi-conductrice (III-V ou II-VI) confinée entre les couches C1 et C3. La couche C2 joue le rôle de la structure photo-détectrice du pixel PxI_D1. Une couche de métal CM est déposée sur la couche conductrice C3 pour former un contact métallique supérieur associé exclusivement à chaque pixel. La structuration de l'interface C3/CM définit un réseau de diffraction. Chaque pixel de la partie optique OPT_D1 est séparé d'un pixel adjacent du détecteur matriciel au moyen d'une barrière en matériau diélectrique BMD. La couche inférieure C1 est commune à une pluralité de pixels et est connectée au potentiel électrique V_{INF} représentant une masse électrique pour tout le dispositif Dis1.

Dans le dispositif Dis1, la couche métallique C1 est un conducteur transparent (ou peu absorbant) qui laisse passer la lumière. Cela rend l'introduction d'une structure de type MIM (Métal-Isolant-Métal) impossible car dans la structure MIM il est nécessaire d'avoir une couche C1 opaque à la lumière incidente.

Dans le cadre de la description de l'invention, on entend par hybridation l'ensemble d'opérations et de techniques spécifiques pour combiner deux parties ayant des fonctions différentes (par exemple, le circuit de lecture ROIC_D1 et la matrice photo détectrice OPT_D1). L'hybridation d'un système optoélectronique induit les problématiques technologiques interdépendantes suivantes :
o l'assemblage de la partie optique et la partie électronique mécaniquement sans affecter les performances optiques et/ou électriques du dispositif hybride.
∘ la pixellisation consistant en la création des pixels et la création d'un accès individualisé au signal généré par chacun des pixels de la matrice de la partie optique.
∘ l'interconnexion consistant en la création d'une architecture d'interconnexion électrique entre chacun des pixels PxI_D1 et l'électrode de lecture associée audit pixel.

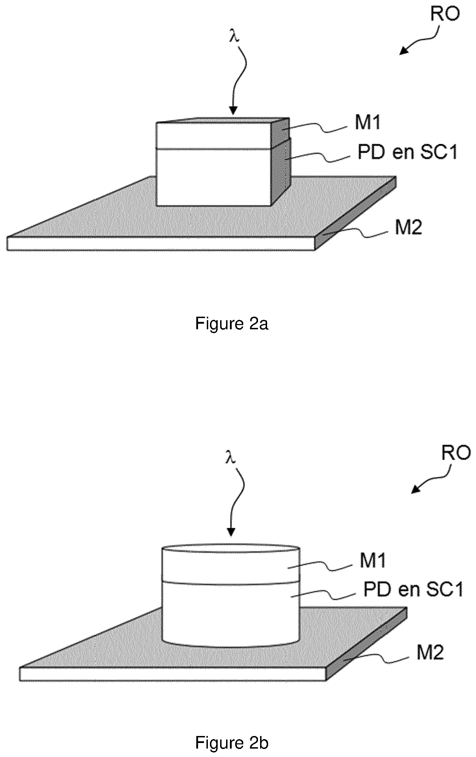

Dans le cas de l'architecture décrite à la figure 1, l'hybridation est réalisée pour chaque pixel au moyen d'une bille métallique B1 qui connecte électriquement l'électrode de lecture EL_D1 à la couche de métal CM formant le contact métallique supérieur associé exclusivement au même pixel. La bille B1 est, par exemple, réalisable avec des billes d'Indium ou micro-piliers en cuivre permettant à chaque pixel d'avoir un contact individualisé avec le circuit de lecture ROIC. Il faut alors fermer le circuit électrique par un contact commun en face avant du photo détecteur, que doit nécessairement traverser le flux incident. En effet, la couche C1 est nécessairement transparente (ou faiblement absorbante) à l'optique étant du côté de l'onde incidente détectée. Cela rend l'intégration de résonateurs de type MIM dans le dispositif selon l'état de l'art impossible techniquement. Les figures 2a et 2b illustrent deux exemples de résonateurs optiques RO de type MIM (Métal/Isolant/ Métal). Il est possible de réaliser un nano-résonateur optique via une microstructure comprenant une structure photo-détectrice PD réalisée dans un matériau semi-conducteur SC1, une couche métallique supérieure M1 jouant le rôle d'un élément rayonnant d'antenne sous-longueur d'ondes et une seconde couche métallique réflectrice M2 jouant le rôle de miroir. La structure photo-détectrice PD est confinée entre la couche métallique réflectrice M2 et la couche métallique supérieure M1.

Les solutions techniques selon l'état de l'art des méthodes de pixellisation, d'assemblage et d'interconnexion sur circuit de lecture ne sont pas applicables pour un système optoélectronique basé sur la technologie de résonateurs optiques de type MIM, à cause de la présence du réflecteur métallique en face non incidente. En effet, deux cas se présentent dans les solutions de l'état de l'art :
o la face incidente est du côté de la couche métallique miroir commun ce qui entraine une non-compatibilité avec une architecture MIM car le miroir doit être opaque dans une telle structure.
∘ la face incidente est du côté de la couche métallique supérieure et dans ce cas il n'est pas évident de réaliser l'interconnexion entre la partie optique et le circuit de lecture intégré ROIC.

L'invention propose une structure de résonateur optique pour les problématiques de pixellisation, d'assemblage et d'interconnexion d'un dispositif optoélectronique comprenant au moins un pixel, chaque pixel étant réalisé via un unique résonateur optique connecté à une unique électrode de lecture du circuit intégré de lecture.

### Art antérieur/ Restrictions de l'état de l'art

La demande de brevet américaine US 1998 5773831A décrit un détecteur d'image infra-rouge comprenant une pluralité de résonateurs optiques qui forment la matrice de détection. L'inconvénient de la solution décrite par cette demande est que la couche photo-détectrice couvre l'intégralité de la surface de la matrice de détection augmentant ainsi la génération de bruit et/ou de courant d'obscurité indésirable.

La demande de brevet américaine US 2011 0156194A1 décrit un détecteur d'image infra-rouge comprenant une pluralité de résonateurs optiques qui forment la matrice de détection. La connexion entre un pixel et le circuit de lecture est réalisée au moyen d'une structure sous forme de clou connecté à une bille métallique. L'inconvénient de la solution décrite par cette demande est que la structure d'interconnexion comprenant des billes métalliques présente une limite physique à l'augmentation de la résolution vu la taille des billes métalliques d'interconnexion. De plus, la couche photo-détectrice couvre l'intégralité de la surface de la matrice de détection augmentant ainsi la génération de bruit et/ou de courant d'obscurité indésirable. De plus, on cite un autre inconvénient lié à la baisse de la performance optique car les photons incidents sur la zone de contact ne seront pas collectés, d'où une perte d'efficacité quantique du détecteur selon l'état de l'art.

### Réponse au problème et apport solution

Pour pallier les limitations des solutions existantes en ce qui concerne la pixellisation, l'assemblage et l'interconnexion d'un dispositif optoélectronique comprenant au moins un résonateur optique connecté à une unique électrode de lecture d'un circuit intégré de lecture, l'invention propose plusieurs modes de réalisation d'une architecture d'un résonateur optique basé sur la technologie MIM et compatible avec un système hybride optoélectronique. L'invention propose en outre des procédés de fabrication pour la réalisation des structures de réonateurs optiques. Les procédés proposés par l'invention concernent des procédés compatibles avec une chaine de production silicium pour la technologie CMOS et des procédés de fabrication de plaquettes (« wafer » en anglais) à base de semiconducteurs de type III-V ou II-VI. Avantageusement, la solution technique selon l'invention permet de réaliser une hybridation de detecteurs matriciels dans le domaine de l'imagerie infrarouge (longueur d'onde de 1µm à 70µm, donc comprenant le THz), et en particulier les spectres du MWIR (mid-wave infrared, 3-5µm) et du LWIR (long-wave infrared, 8-12µm) pour l'imagerie thermique. L'architecture proposée par l'invention permet d'améliorer la performance de ce type de dispotif car l'hybridation du système est adaptée aux contraintes techniques des nano-résonateurs optiques de type MIM.

### Résumé /Revendications

L'invention a pour objet un dispositif optoélectronique comprenant au moins un pixel, chaque pixel comprenant :
o un résonateur optique comprenant une structure photo-détectrice confinée entre une première couche métallique et une seconde couche métallique réflectrice ;
o et un circuit intégré de lecture disposé sur un substrat et comprenant au moins une électrode de lecture enterrée dédiée au pixel et au moins une couche externe métallique ou diélectrique.
Un ensemble comprenant au moins la première couche du résonateur et la couche externe du circuit intégré est dénommé structure planaire d'assemblage. La première couche métallique est connectée à l'électrode de lecture au moyen d'un via métallique traversant la structure du résonateur optique et la structure planaire d'assemblage. Le via métallique est électriquement isolé de la structure photo-détectrice et de la structure planaire d'assemblage.

Selon un aspect particulier de l'invention, le via métallique comporte une couche de passivation interne de matériau diélectrique déposée sur ses parois internes pour l'isoler électriquement de la seconde couche métallique réflectrice et de la structure planaire d'assemblage.

Selon un aspect particulier de l'invention, le via métallique a un diamètre inférieur à la longueur d'onde absorbée par le résonateur optique divisée par le triple de l'indice de réfraction effectif de la structure photo-détectrice.

Selon un aspect particulier de l'invention, la couche métallique réflectrice est commune à tous les pixels.

Selon un aspect particulier de l'invention, la structure planaire d'assemblage comprend la seconde couche métallique réflectrice, une troisième couche métallique connectée à la masse électrique appartenant au circuit intégré de lecture et une couche de passivation en matériau diélectrique appartenant au circuit intégré de lecture.

Selon un aspect particulier de l'invention, au moins une dimension d'un résonateur, choisie parmi largeur, longueur, est comprise dans l'intervalle [λ/2n - 50% ; λ/2n + 50%] avec λ longueur d'onde incidente et n l'indice de réfraction effectif de la structure photo détectrice.

Selon un aspect particulier de l'invention, la hauteur de la structure photo-détectrice est comprise dans l'intervalle [λ/4n - 50% ; λ/2n + 50%] avec λ longueur d'onde incidente et n l'indice de réfraction effectif de la structure photo détectrice.

Selon un aspect particulier de l'invention, la première couche métallique couvre la totalité de la surface de la mésa photo-détectrice.

Selon un aspect particulier de l'invention, la première couche métallique couvre une partie de la surface de la structure photo-détectrice. La première couche métallique est intégralement couverte par une couche d'encapsulation en matériau diélectrique.

Selon un aspect particulier de l'invention, l'entrée du via métallique est entourée par un anneau d'arrêt de gravure en un matériau diélectrique.

Selon un aspect particulier de l'invention, la distance entre deux pixels adjacents est supérieure ou égale à la longueur d'onde absorbée par le résonateur optique divisée par le double de l'indice de réfraction effectif de la structure photo-détectrice.

Selon un aspect particulier de l'invention, la structure photo détectrice est une couche réalisée en un premier matériau semi-conducteur II-VI ou III-V ou un empilement d'une pluralité de couches d'une pluralité de matériaux semi-conducteurs.

Selon un aspect particulier de l'invention, le circuit intégré de lecture est réalisé sur un substrat en silicium.

L'invention a pour objet en outre un procédé de fabrication d'un dispositif optoélectronique, le procédé comprenant les étapes consistant à :
- assembler d'une part une première structure planaire comprenant un premier substrat, un ensemble d'au moins une couche photo-détectrice et une couche métallique réflectrice ;
   et d'autre part un circuit intégré de lecture déposé sur un deuxième substrat et comprenant au moins une électrode de lecture enterrée et une couche externe métallique ou diélectrique.
   Un ensemble comprenant au moins la couche métallique réflectrice et la couche externe du circuit intégré de lecture est dénommé structure planaire d'assemblage ;
- détacher le premier substrat ;
- pour chaque électrode enterrée : réaliser un résonateur optique et connecter ledit résonateur optique à l'électrode enterrée associée au moyen d'un via métallique traversant la structure du résonateur optique et la structure planaire d'assemblage. L'étape de réalisation et de connexion du résonateur optique est réalisée en :
   - Gravant un trou d'interconnexion traversant ledit ensemble d'au moins une couche photo-détectrice jusqu'à l'électrode enterrée;
   - Réalisant une couche de passivation en diélectrique déposée sur les parois internes du trou d'interconnexion ;
   - Déposant un matériau conducteur sur une surface externe dudit ensemble d'au moins une couche photo-détectrice, centrée sur le trou d'interconnexion pour réaliser une première couche métallique ;
   - déposant le matériau conducteur pour remplir le trou d'interconnexion du matériau conducteur et pour réaliser le via métallique connectant électriquement ladite première couche métallique à l'électrode enterrée ;
   - gravant sélectivement chacune des couches dudit ensemble d'au moins une couche photo-détectrice pour réaliser une structure photo-détectrice du résonateur optique ; la structure photo-détectrice étant confinée entre la couche métallique réflectrice et ladite première couche métallique.

Selon un aspect particulier de l'invention, l'étape de réalisation et de connexion d'un résonateur optique à l'électrode enterrée associée comprend en outre les sous-étapes suivantes :
o déposer une couche d'encapsulation en matériau diélectrique couvrant la première couche métallique.
∘ graver sélectivement la couche d'encapsulation pour garder au moins les parties couvrant la première couche métallique.

Selon un aspect particulier de l'invention, le procédé de fabrication d'un dispositif optoélectronique comprend en outre:
- une étape de dépôt d'une couche d'arrêt de gravure sur une couche externe dudit ensemble d'au moins une couche photo-détectrice préalable à l'étape de réalisation et de connexion d'un résonateur optique à l'électrode enterrée associée ;
- dans cet aspect particulier de l'invention, l'étape de réalisation et de connexion d'un résonateur optique à l'électrode enterrée associée comprend en outre les sous-étapes suivantes :
   o graver sélectivement la couche d'arrêt de gravure pour réaliser un anneau d'arrêt de gravure entourant l'accès au trou d'interconnexion et une cavité autour dudit anneau d'arrêt de gravure servant à accueillir une partie de la première couche métallique
   o déposer une couche de matériau conducteur sur le via de manière à le connecter à la première couche métallique.

Selon un aspect particulier de l'invention, le matériau conducteur déposé pour la réalisation de la première couche métallique et du via métallique est l'or ou le platine.

Selon un aspect particulier de l'invention, le matériau conducteur déposé pour la réalisation de la première couche métallique et du via métallique est le cuivre ou l'aluminium ou le tungstène.

Selon un aspect particulier de l'invention, l'étape de réalisation simultanée des trous d'interconnexion et des résonateurs s'effectue par lithographie puis gravure, la technologie de lithographie étant choisie parmi : par faisceau d'électrons ; par nano-impression ; par lithographie optique, et la technologie de gravure étant choisie parmi la gravure ionique, gravure chimique ou plasma.

### Brève description des dessins

D'autres caractéristiques et avantages de la présente invention apparaîtront mieux à la lecture de la description qui suit en relation aux dessins annexés suivants.
La figure 1 illustre une vue en coupe partielle d'un système hybride optoélectronique selon l'état de l'art ayant une partie optique comprenant un réseau de diffraction.
La figure 2a illustre une vue en perspective d'un exemple de résonateur optique sous forme cubique.
La figure 2b illustre une vue en perspective d'un exemple de résonateur optique sous forme cylindrique.
La figure 3 illustre un schéma de deux résonateurs optiques intégrés dans un détecteur matriciel d'images dans le domaine de fréquences infrarouges.
La figure 4a illustre un premier mode de réalisation de l'hybridation d'un résonateur optique appartenant à un système hybride optoélectronique.
La figure 4b illustre un procédé de fabrication pour réaliser un résonateur optique appartenant à un système hybride optoélectronique selon le premier mode de réalisation.
La figure 5a illustre un deuxième mode de réalisation de l'hybridation d'un résonateur optique appartenant à un système hybride optoélectronique.
La figure 5b illustre un procédé de fabrication pour réaliser un résonateur optique appartenant à un système hybride optoélectronique selon le deuxième mode de réalisation.
La figure 5c illustre une vue en coupe théorique agrandie au niveau d'un trou d'interconnexion passivé réalisé avec le procédé de la figure 5b.
La figure 5d illustre une vue en coupe réaliste agrandie au niveau d'un trou d'interconnexion passivé réalisé avec le procédé de la figure 5b.
La figure 6a illustre un troisième mode de réalisation de l'hybridation d'un résonateur optique appartenant à un système hybride optoélectronique.
La figure 6b illustre un procédé de fabrication pour réaliser un résonateur optique appartenant à un système hybride optoélectronique selon le troisième mode de réalisation.

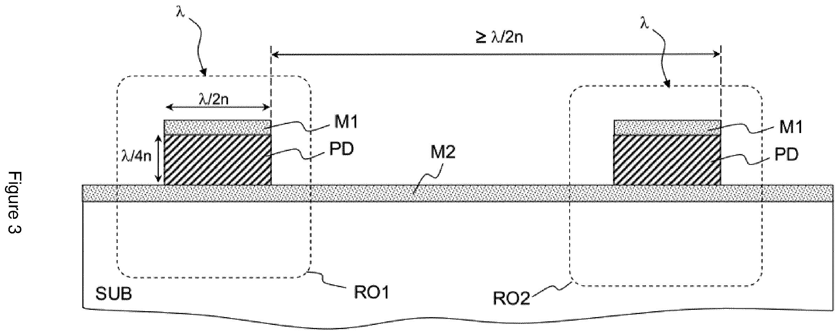

Nous allons commencer par introduire la structure de base d'un couple de résonateurs optiques RO1 et RO2 non intégrés dans un système hybride. La figure 3 illustre un schéma de deux résonateurs optiques intégrés dans un détecteur matriciel d'images dans le domaine de fréquences infrarouges.

Les résonateurs optiques RO1 et RO2 présentés à la figure 3 reposent sur un substrat SUB en matériau semi-conducteur. Nous nous limitons à ce stade à représenter le substrat SUB pour simplifier la représentation.

Chaque résonateur optique RO1 ou RO2 comprend une structure photo-détectrice PD réalisée dans un premier matériau semi-conducteur SC1 et définissant une mesa, une première couche métallique M1 et une seconde couche métallique réflectrice M2. La structure en mesa photo-détectrice SC2 est confinée entre la première couche métallique M1 et la seconde couche métallique réflectrice M2. On entend par « mesa » une microstructure ou nanostructure correspondant à un volume reposant sur un plan et ayant une surface supérieure plane.

La structure photo-détectrice PD est située dans la cavité photonique que constitue le résonateur optique RO1 (ou RO2). Cette structure est réalisée via un matériau de type III-V tel que, à titre d'exemple, l'arséniure de gallium, arséniure d'indium, nitrure de gallium, antimoniure de gallium, phosphure de bore, ainsi que leurs alliages ternaires, quaternaires ou quinaires.

Alternativement, il est possible de réaliser des homo-jonctions photo détectrices obtenues via des variations ou gradients de dopage d'une structure en matériau semi-conducteur.

Alternativement, il est possible de réaliser la structure photo-détectrice d'un résonateur optique RO1 (ou RO2) avec un empilement d'une pluralité de couches. L'empilement est composé de matériaux semi-conducteurs différents formant ainsi une hétéro-structure photo détectrice. Les matériaux semi-conducteurs utilisés pour la réalisation de l'empilement des couches de l'hétéro-structure photo détectrice sont de type III-V tel que, à titre d'exemple, l'arséniure de gallium, arséniure d'indium, nitrure de gallium, antimoniure de gallium, phosphure de bore, ainsi que leurs alliages ternaires ou quaternaires ou quinaires. Le dopage de ces couches (N ou P) permet de définir des architectures de photodiodes ou de photoconducteurs.

Selon un aspect particulier de l'invention, la structure photo détectrice correspond à un ensemble de boites quantiques colloïdales CQD (acronyme du terme anglais Colloidal Quantum Dots).

La couche (ou structure) photo détectrice PD repose sur la couche métallique réflectrice M2 jouant le rôle de miroir.

Généralement, la couche réflectrice M2 est commune à tous les résonateurs optiques RO du dispositif hybride OPT étant connectée électriquement à la masse électrique du dispositif.

Dans un autre mode de réalisation, il est envisageable d'avoir une couche réflectrice M2 dédiée à chaque pixel et donc pour chaque résonateur optique RO puisque chaque résonateur optique constitue un pixel.

La couche métallique M1 joue le rôle d'élément rayonnant d'une nano-antenne sous-longueur d'onde pour un résonateur optique tel que décrit à la figure 3. Elle est déposée sur la surface apparente de la mesa photo détectrice PD. Le dimensionnement à l'échelle nanométrique du résonateur lui permet d'absorber des modes particuliers d'une onde incidente du côté de la couche supérieure M1 et ayant une longueur d'onde λ dans le domaine de l'infra-rouge.

A titre indicatif, la couche réflectrice M2 et la couche supérieure M1 peuvent être réalisées avec de l'or (Au) ayant une épaisseur de couche variant entre 25nm et 500nm pour la couche réflectrice M2 et une épaisseur de couche variant entre 150nm et 1000nm pour une couche supérieure M1. De plus et à titre d'exemple, il est possible de réaliser les couches métalliques M1 et M2 avec du cuivre, l'aluminium, le palladium, le platine, l'argent et le tungstène.

Avantageusement, si on désigne par n l'indice de réfraction du matériau de la mésa photo détectrice PD, le résonateur RO1 (ou RO2) est dimensionné de la manière suivante : au moins une dimension d'un résonateur (et donc de la couche supérieure M1), choisie parmi la largeur ou la longueur, est comprise dans l'intervalle [λ/2n - 50% ; λ/2n + 50%] et la hauteur de la couche photo détectrice PD est comprise dans l'intervalle [λ/4n - 50% ; λ/2n + 50%]. De plus, la distance séparant deux résonateurs optiques adjacents est supérieure à λ/2n.

Ces intervalles de dimensionnement permettent de réaliser le fonctionnement de résonateur par les microstructures RO1 et RO2 décrites précédemment. En effet, chacun des résonateurs exalte le couplage lumière-matière entre le mode de cavité verticale TM0 et la couche photosensible PD, permettant d'exalter la réponse des technologies à faible efficacité quantique, comme les détecteurs inter-sous-bandes à puits quantiques (QWIPs et QCDs) ou les boites quantiques colloïdales II-VI (CQD).

Pour un résonateur, lorsque la structure est résonante, la lumière est alors guidée et concentrée dans la cavité photo-détectrice PD sous la couche supérieure M1, permettant de garantir une fonction de transfert de modulation (MTF) optimale, en diminuant (voir supprimant complètement) les phénomènes de diaphonies (crosstalk en Anglais) optiques et électriques entre les résonateurs. Sachant que dans le dispositif hybride OPT, chaque pixel correspond à un ou plusieurs résonateurs connectés entre eux, la structure décrite par la figure 3 permet alors de réduire le pas pixel à sa dimension ultime correspondant à un pas sous-longueur d'onde. De plus, le volume effectif de semi-conducteur est beaucoup plus réduit que dans les dispositifs optoélectroniques planaires. Ainsi, le courant et le bruit d'obscurité sont réduits dans le dispositif OPT comprenant des résonateurs RO. Nous rajoutons que cette architecture est intrinsèquement rapide car elle présente une faible capacité du pixel.

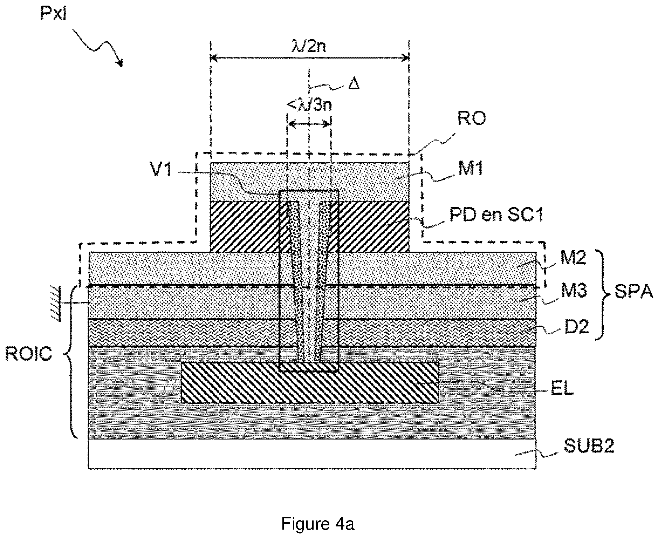

La figure 4a illustre un premier mode de réalisation d'un résonateur optique RO selon l'invention, hybridé avec un circuit intégré de lecture ROIC en connectant la couche métallique supérieure M1 du résonateur RO à une électrode de lecture EL enterrée appartenant au circuit intégré de lecture ROIC.

Un dispositif hybride optoélectronique comprend au moins un pixel PxI formant une matrice. Dans la solution décrite par l'invention, chaque pixel comprend un résonateur optique RO dont la structure photodétectrice PD est réalisée dans un premier matériau semi-conducteur SC1 généralement de type III-V. Le dispositif comprend en outre un circuit intégré de lecture ROIC réalisé dans un second matériau semi-conducteur SC2 généralement en silicium et disposé sur un substrat en silicium Sub2. Le circuit de lecture ROIC est généralement réalisé au moyen d'une pluralité de transistors et de couches minces en matériau conducteurs, semi-conducteurs ou diélectriques selon la technologie CMOS (non représentés ici pour simplifier l'illustration) sur le substrat Sub2 en silicium.

La plaquette (« wafer » en Anglais) comprenant les couches composant la partie optique et la plaquette comprenant le circuit de lecture ROIC sont assemblées par une structure planaire d'assemblage SPA comprenant un empilement de couches appartenant au nano-résonateur optique RO ou au circuit intégré de lecture ROIC. Dans l'exemple illustré par la figure 4a, la structure planaire d'assemblage est composée d'un côté de la couche métallique réflectrice M2 appartenant à la partie optique et de l'autre côté de l'empilement de couches composé de la couche métallique M3 connectée à la masse électrique du circuit ROIC et la couche de passivation en diélectrique D2 du circuit ROIC. Plus de détails sur le procédé d'assemblage seront exposés ultérieurement.

Alternativement, Il est possible de réaliser un assemblage non pas métal-métal comme illustré sur la figure 4a mais un assemblage diélectrique-diélectrique. La structure planaire d'assemblage SPA dans ce cas est composée de la couche de passivation externe diélectrique de la partie optique et la couche de passivation externe en diélectrique du circuit intégré de lecture ROIC ainsi que la couche métallique miroir M2.

Comme décrit précédemment, le résonateur optique RO comprend une structure photo-détectrice PD réalisée en matériau semi-conducteur de type III-V et définissant une mesa par exemple, une couche métallique supérieure M1 et une couche métallique réflectrice M2. La structure photo-détectrice PD est confinée entre la couche métallique réflectrice M2 et la couche métallique supérieure M1 jouant le rôle d'élément rayonnant d'une antenne sous-longueur d'onde.

L'hybridation d'un pixel Pxl appartenant au détecteur d'image OPT selon l'invention est réalisée au moyen d'un via métallique de connexion V1 connectant électriquement la couche métallique supérieure M1 du résonateur optique RO (partie optique) appartenant au pixel Pxl à l'électrode de lecture EL associée au même pixel et enterrée dans la plaquette du circuit ROIC (partie électrique). Le via de connexion V1 est traversant à partir de la couche métallique supérieure M1 vers l'électrode enterrée EL en passant par la structure photo détectrice PD et la structure planaire d'assemblage SPA. Cette solution permet de réaliser une pixellisation car elle permet de lire individuellement le signal généré par chaque pixel comprenant un unique résonateur RO traversé par un via V1. Cette solution est compatible avec un assemblage de type « wafer to wafer » pouvant être traduit par plaquette à plaquette tel que représenté sur la figure 4a à titre indicatif. Cette solution permet de réaliser une interconnexion d'un système hybride permettant la création d'une architecture d'interconnexion entre chacun des pixels PxI et l'électrode de lecture associée à chaque pixel.

Cette solution est compatible aussi avec un assemblage de type « die to wafer » pouvant être traduit par puce à plaquette. On entend ici par puce un circuit intégré préalablement fabriqué sur une plaquette de semi-conducteur et préalablement découpé de la plaquette sans montage d'un boitier. Cette solution est compatible aussi avec un assemblage de type « multi-wafer to wafer » pouvant être traduit par multi-plaquette à plaquette.

Le via de connexion traverse l'axe central Δ de la structure du résonateur RO à partir de la couche métallique supérieure M1. Le diamètre du via V1 au niveau de l'accès à l'interface avec la couche M1 est inférieur à λ/3n avec λ la longueur d'onde de résonance et n l'indice de réfraction effectif du premier matériau semi-conducteur SC1. Le via est réalisé au centre du pixel car le mode optique horizontal TM1 a un champ faible au centre. On limite ainsi par ce positionnement la perturbation du fonctionnement du résonateur par le via. On réalise ainsi la pixellisation et l'interconnexion sans dégrader la performance du résonateur optique.

Le via V1 doit traverser la structure planaire d'assemblage comprenant la couche métallique réflectrice connectée à la masse électrique et commune à l'ensemble des pixels de la matrice.

De plus, pour chaque pixel PxI , le via V1 traversant le résonateur RO associé doit connecter individuellement la couche métallique M1 à l'électrode enterrée de lecture EL.

Ainsi, le via V1 est passivé par le dépôt d'une couche de passivation interne Pl de matériau diélectrique déposée sur ses parois internes pour l'isoler électriquement de la seconde couche métallique réflectrice M2 et de la structure planaire d'assemblage SPA. La couche interne de passivation Pl assure aussi un rôle de protection optique en isolant le via V1 de la structure photo-détectrice PD pour éviter d'altérer les performances optiques du résonateur RO.

La structure d'un pixel de détecteur matriciel infrarouge selon l'invention décrite à la figure 4a est réalisable via un procédé de fabrication basé sur les étapes technologiques d'une ligne de production pour la fabrication des circuits ou microsystèmes à base de semi-conducteurs III-V.

Par « procédé III-V » on entend les procédés trouvés dans des environnements de salle blanche traitant couramment des plaquettes (« wafers » en anglais) au format 100mm ou inférieurs. Les plaquettes sont souvent traitées individuellement, ou par lot de quelques unités au maximum. Une fraction majoritaire de la manipulation des tranches est manuelle. Les opérations de lithographies se font par des procédés contact ou par projection, avec des résolutions de l'ordre du µm allant jusqu'à 500nm. La structuration des couches et structures métalliques est réalisée par des dépôts de type « lift-off » ou gravure ionique. Les métaux généralement utilisés sont les métaux nobles comme le platine (Pt), l'or (Au) et l'argent (Ag). Les étapes technologiques de collage et de planarisation de type CMP sont peu courantes avec ce type de procédé.

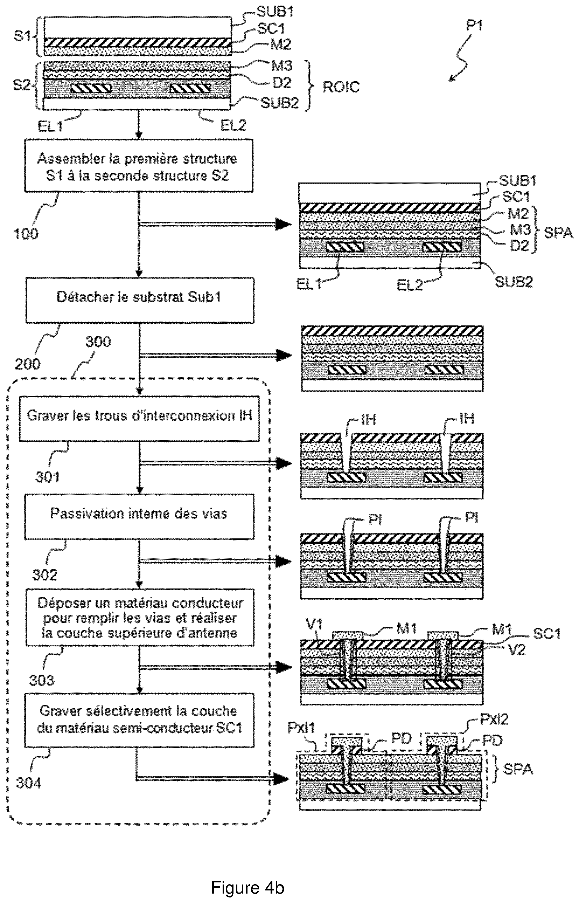

L'invention propose un procédé de type « procédé III-V » pour fabriquer un résonateur optique RO mais aussi pour réaliser l'assemblage, la pixellisation et l'interconnexion du pixel PxI contenant le résonateur optique fabriqué. Nous nous limiterons à représenter les étapes technologiques du procédé P1 pour deux pixels Pxl1 et PxI2 pour simplifier la compréhension du procédé. Cependant, les étapes du procédé sont généralisables pour une pluralité de pixels appartenant au même système hybride et elles sont réalisables d'une façon simultanée pour toute la matrice de pixels. Les étapes de ce procédé sont illustrées à la figure 4b.

La première étape 100 du procédé P1 consiste à assembler par une structure planaire d'assemblage SPA, une première structure planaire S1 à un circuit intégré de lecture ROIC préalablement fabriqués. La première structure S1 présente l'échantillon utilisé pour fabriquer la partie optique et comprend un empilement d'une couche en un matériau semi-conducteur de type III-V (formant une couche photo détectrice) et d'une couche métallique réflectrice M2. Comme expliqué précédemment, il est envisageable d'utiliser pour la partie optique une première structure planaire S1 comprenant un empilement d'une pluralité de couches en différents matériaux semi-conducteurs formant ensemble une hétéro-structure de couches photo-détectrices qui vont servir pour la fabrication des structures photo-détectrices des résonateurs. Nous nous limitons à présenter une seule couche photo détectrice SC1 dans les illustrations suivantes par souci de simplification mais sans perte de généralité. La première structure est déposée sur un premier substrat Sub1. Le circuit intégré de lecture ROIC est réalisé dans une plaquette silicium, il est déposé sur un deuxième substrat Sub2 et il comprend deux électrodes de lecture enterrées EL1 et EL2. La première électrode EL1 est destinée à lire le signal du premier pixel Pxl1 ; la seconde électrode EL2 est destinée à lire le signal du premier pixel PxI2.

L'assemblage est réalisé par collage, technique en plein développement et qui constitue un progrès important pour la réalisation d'étapes technologiques dites « above IC », c'est-à-dire d'étapes réalisables directement sur la plaque du circuit de lecture ROIC, typiquement de type CMOS, et de manière collective sur l'ensemble des puces. Cette compatibilité avec les moyens de fabrication CMOS est adaptée à une baisse significative des coûts de production et à la possibilité d'atteindre des motifs technologiques de taille plus fine.

Le résultat de l'étape d'assemblage 100 est illustré dans la vue en coupe 100a où on observe la structure S1 assemblée au circuit de lecture ROIC tel que la structure planaire d'assemblage SPA est constituée de la couche métallique réflectrice M2 appartenant à la première structure S1 et de l'empilement composé d'une couche métallique M3 connectée à la masse électrique du circuit de lecture ROIC et d'une couche de passivation du circuit ROIC notée D2 en matériau diélectrique. L'étape d'assemblage 100 assure alors la connexion électrique de la couche métallique réflectrice M2 à la masse électrique globale du système hybride.

La deuxième étape 200 consiste à détacher le substrat Sub1 pour garder seulement le substrat Sub2 sur lequel est fabriqué le circuit de lecture ROIC. La structure obtenue suite à la réalisation de l'étape 200 est illustrée dans la vue en coupe 200a.

La troisième étape 300 consiste à réaliser, pour chaque électrode de lecture enterrée EL, un résonateur optique RO et à connecter ledit résonateur optique RO à l'électrode enterrée associée EL. Plus précisément, la connexion est réalisée entre la couche métallique supérieure M1 de chaque résonateur et l'électrode de lecture associée. La connexion est réalisée au moyen d'un via métallique V1 traversant la structure du résonateur optique RO et la structure planaire d'assemblage SPA comme décrit précédemment.

L'étape 300 de réalisation et de connexion du résonateur optique RO1 (et respectivement RO2) comprend une succession de sous-étapes compatibles avec un procédé de type « III-V ».

La première sous étape 301 consiste à réaliser un trou d'interconnexion IH traversant de la couche photo-détectrice (ou l'empilement des couches photo-détectrices) du premier matériau semi-conducteur SC1 jusqu'à l'électrode enterrée EL1 en passant par la structure planaire d'assemblage SPA. La sous-étape 301 est, par exemple, réalisée au moyen d'une opération de gravure ionique ou plasma. Les trous d'interconnexion IH obtenus suite à la réalisation de la sous-étape 301 sont illustrés dans la vue en coupe 301a.

La deuxième sous-étape 302 consiste à réaliser une couche de passivation interne PI pour chacun des vias de connexion V1. Cette sous-étape est, par exemple, réalisée en déposant dans un premier temps une couche en diélectrique sur l'ensemble de la plaquette (ou « wafer ») de façon à remplir les trous IH, puis en gravant sélectivement la couche en diélectrique pour garder seulement une partie de la couche déposée couvrant les parois intérieures de chacun des trous IH. Dans l'illustration 302a du résultat de la sous étape de passivation des vias 302, on observe les couches de passivation internes qui couvrent les parois tout en laissant la possibilité d'accès aux électrodes de lecture EL à travers les trous IH.

La troisième sous-étape 303 consiste à déposer un matériau conducteur sur une surface de la couche du premier matériau semi-conducteur SC1, centrée sur chacun des trous d'interconnexion IH pour réaliser la couche métallique supérieure M1 de chacun des résonateurs RO. Simultanément à la réalisation des couches métalliques supérieures, la sous-étape 303 permet en outre de remplir les trous d'interconnexion IH pour réaliser pour chaque résonateur RO le via métallique V1 connectant électriquement la couche métallique supérieure M1 à l'électrode enterrée EL appartenant au même pixel Pxl.

La sous-étape 303 est, par exemple, réalisée via un procédé de dépôt de type « lift-off ». Il s'agit d'une technique additive utilisée en microtechnique visant à créer des motifs d'un matériau cible (dans ce cas les couches supérieures M1) sur la surface d'un substrat (dans ce cas l'empilement des couches M2 et SC2) en utilisant un matériau sacrificiel (généralement une résine photosensible). La structure obtenue suite à la réalisation de la sous-étape 303 est illustrée dans la vue en coupe 303a. on observe les couches supérieures M1 de chacun des résonateurs RO1 et RO2.

La quatrième sous-étape 304 consiste à graver sélectivement la couche du premier matériau semi-conducteur SC1 pour réaliser pour chaque résonateur une structure photo-détectrice PD. Sur l'illustration 304a du résultat de cette sous-étape, on observe la structure photo-détectrice PD confinée entre la couche métallique réflectrice M2, connectée à la masse électrique, et la couche métallique supérieure M1, connectée à l'électrode de lecture EL.

Ainsi, le procédé P1 selon un mode de réalisation de l'invention permet de réaliser au moins un résonateur optique RO selon l'invention formant un pixel Pxl d'un système optoélectronique tout en réalisant l'opération d'hybridation de la partie optique avec la partie électrique du système.

Nous allons dans la partie suivante décrire un second mode de réalisation de la structure de résonateur optique RO selon l'invention compatible avec un « procédé CMOS » d'une ligne de production en fonderie silicium. Par « procédé CMOS », on entend les procédés trouvés dans des environnements salle blanche traitant des plaquettes (ou « wafer ») de large format (200mm, 300mm, 450mm). Les plaquettes sont manipulées par des automates, et sont souvent traités par lots de 10 à 25 unités qui se branchent directement sur les équipements. Les opérations de lithographie sont des lithographies de type pas à pas réalisées par projection avec des résolutions largement submicroniques. La structuration des métaux est réalisée par des procédés damascènes comprenant des étapes de dépôt d'une couche isolante suivi par une gravure de la couche d'isolant puis le dépôt du métal dans la cavité créée, et finalement une planarisation de type CMP pour retirer le métal excédentaire. Les structures de métaux peuvent aussi être réalisées par usinage ionique. Les métaux nobles sont moins courants car ils contaminent les structures de type CMOS, à l'exception du cuivre qui est omniprésent, du fait de son utilisation pour la réalisation des niveaux d'interconnexion entre les transistors. La gestion de la contamination par des structures métalliques est réalisée via des étapes de décontamination, et/ou par encapsulation.

L'utilisation d'un procédé de type CMOS pour fabriquer les systèmes hybrides permet un accès à des lignes de production de slilicium et donc à une fabrication présentant un bas coût et de grands volumes.

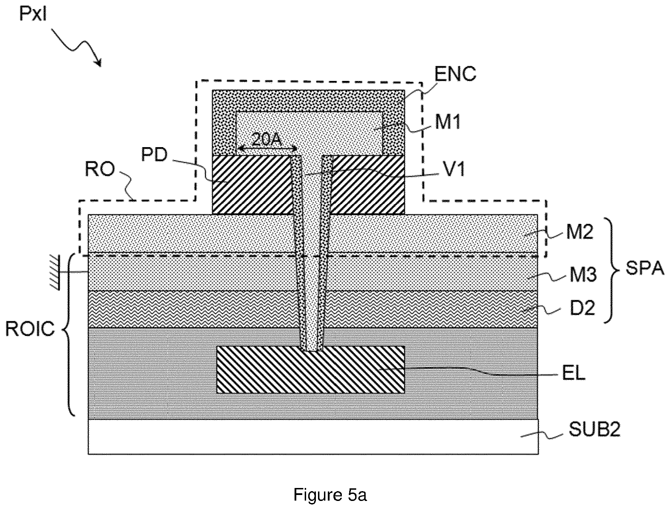

La figure 5a illustre un deuxième mode de réalisation de l'hybridation d'un résonateur optique appartenant à un système hybride optoélectronique, selon l'invention. Ce second mode de réalisation est compatible avec un « procédé CMOS ».

Le deuxième mode de réalisation du résonateur optique RO diffère du premier mode de réalisation par les caractéristiques suivantes :
o la couche métallique supérieure M1 couvre une partie de la surface notée 20A de la structure photo-détectrice PD et non sa totalité comme dans le premier mode de réalisation,
o la couche métallique supérieure M1 est encapsulée par une couche d'encapsulation ENC en matériau diélectrique pour éviter la migration du cuivre par exemple contaminant les autres composants du système.

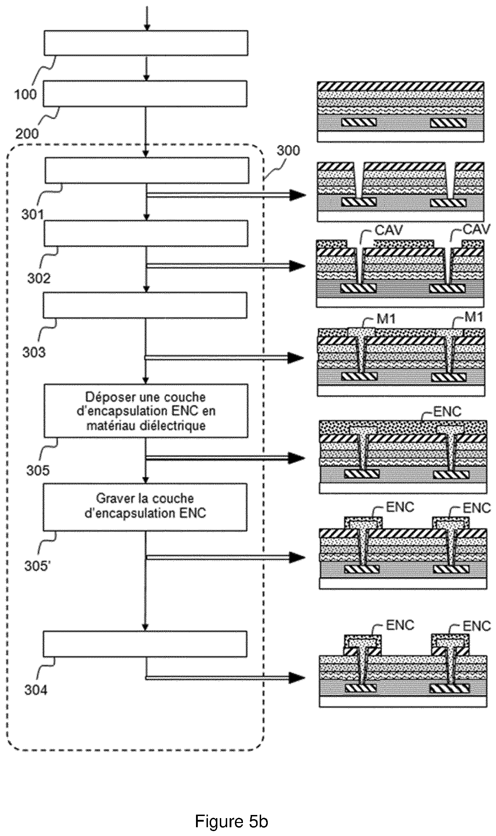

La figure 5b illustre un procédé de fabrication P2 pour réaliser un résonateur optique appartenant à un système hybride optoélectronique selon un deuxième mode de réalisation de l'invention.

Le procédé de fabrication P2 est un « procédé CMOS ». Les étapes d'assemblage 100 et de détachement 200 sont similaires au procédé P1 décrit précédemment.

L'étape 300 de réalisation et de connexion du résonateur optique RO1 (et respectivement RO2) comprend une succession de sous-étapes compatibles avec un procédé de type « CMOS ».

La sous-étape 301 de gravure des trous IH est similaire à celle du procédé P1 décrit précédemment.

La sous-étape 302 de passivation interne des vias V1 reprend le même principe que celle du procédé P1 avec une différence: la gravure sélective de la couche en diélectrique définit des cavités notées Cav au niveau des accès aux trous IH qui vont servir ultérieurement à accueillir les structures métalliques supérieures M1 de chacun des résonateurs. Sur l'illustration 302b du résultat de cette sous-étape, on observe les cavités Cav obtenues suite à l'opération de gravure.

La sous-étape 303 de réalisation des couches métalliques supérieures M1 est réalisée par des procédés damascènes comme décrit précédemment. Sur l'illustration 303b, on observe les couches métalliques M1 remplissant les cavités Cav.

Dans le procédé P2, l'étape 300 comprend en outre une sous-étape 305 de dépôt d'une couche d'encapsulation en matériau diélectrique couvrant l'ensemble des couches métalliques supérieures M1. La sous-étape 305 est suivie d'une sous-étape 305' de gravure sélective de la couche en matériau diélectrique préalablement déposée pour garder au moins les parties couvrant la couche métallique supérieure M1 réalisant ainsi une couche d'encapsulation ENC tel que décrit sur la figure 5a.

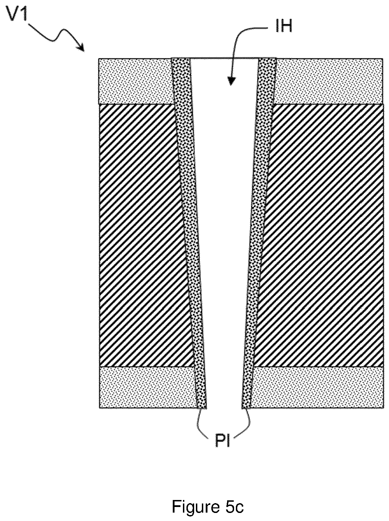

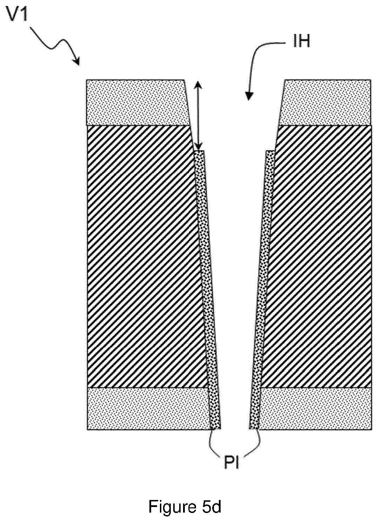

La figure 5c illustre une vue en coupe théorique agrandie au niveau d'un trou d'interconnexion passivé réalisé avec le procédé de la figure 5b. D'un autre côté, la figure 5d illustre une vue en coupe réaliste agrandie au niveau d'un trou d'interconnexion passivé réalisé avec le procédé de la figure 5b.

La sous-étape 302 de passivation interne des vias V1 comprend une opération de gravure de la couche en diélectrique pour créer les cavités Cav et ne garder qu'une fine couche de diélectrique au niveau des parois internes d'un trou d'interconnexion IH. La figure 5c illustre une vue en coupe agrandie de la structure idéalement obtenue par cette sous-étape. Cependant, d'un point de vue pratique, la couche en diélectrique est généralement sur-gravée pour éviter les risques de coupe-circuit au niveau de l'accès au via V1. La structure obtenue par sur-gravure est illustrée sur la figure 5d : dans ce cas plus réaliste, il existe un risque de court-circuit entre la structure photo-détectrice PD et la couche métallique supérieure M1. En effet, la partie supérieure de la structure photo-détectrice PD au niveau trou d'interconnexion IH est non couverte par la couche diélectrique. Cette partie sera alors en contact direct avec le métal déposé pour remplir le via V1 affectant ainsi les performances du résonateur optique RO.

Un troisième mode de réalisation de l'architecture d'un résonateur optique selon l'invention permet de tenir compte des contraintes décrites à la figure 5d.

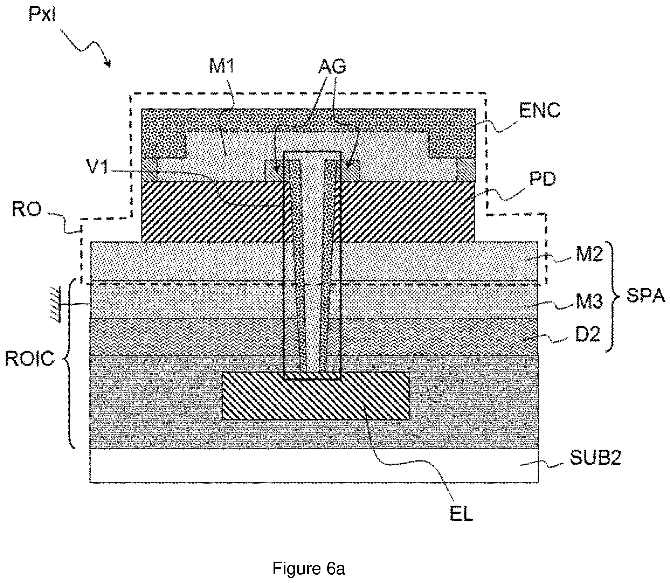

La figure 6a illustre un troisième mode de réalisation de l'hybridation d'un résonateur optique appartenant à un système hybride optoélectronique permettant de surmonter la limitation décrite précédemment. En effet, Le troisième mode de réalisation du résonateur optique RO diffère du second mode de réalisation par la caractéristique suivante : l'entrée du via métallique V1 est entourée par un anneau d'arrêt de gravure AG (pouvant être appelé aussi anneau d'arrêt de polissage) réalisé avec un matériau diélectrique. Cette structure d'anneau permet d'arrêter la gravure de la couche électrique de passivation exactement au niveau des accès aux trous d'interconnexion IH de chacun des vias V1. Cette solution impose la réalisation d'une couche supérieure M1 ayant une épaisseur plus importante dans la zone centrale couvrant l'accès au via V1 et l'anneau d'arrêt de gravure AG et une épaisseur plus faible dans une zone périphérique.

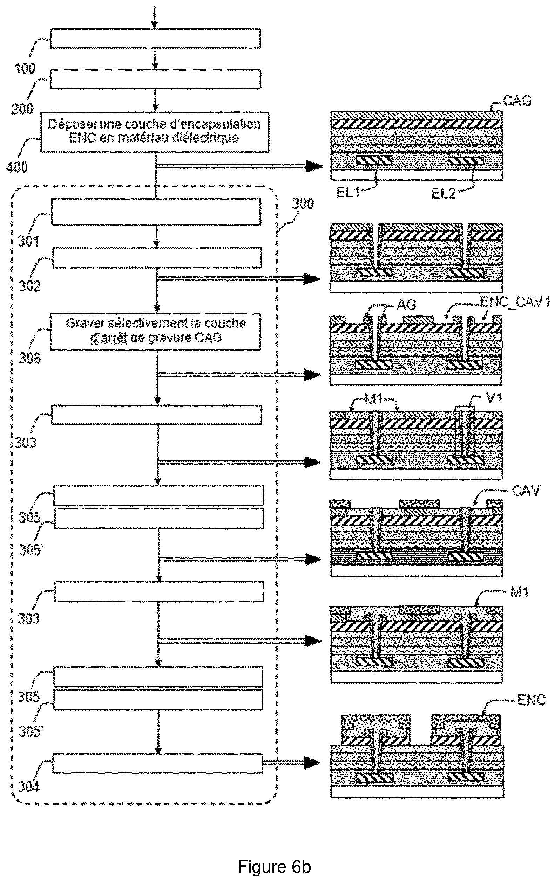

La figure 6b illustre un procédé de fabrication P3 pour réaliser un résonateur optique appartenant à un système hybride optoélectronique selon le troisième mode de réalisation.

Le procédé de fabrication P3 est un « procédé CMOS ». Les étapes d'assemblage 100 et de détachement 200 sont similaires aux procédés P1 et P2 décrits précédemment.

Dans le procédé P3, la troisième étape 400 consiste à déposer une couche d'arrêt de gravure CAG sur la couche du premier matériau semi-conducteur SC1 préalablement à l'étape de réalisation et de connexion 300 d'un résonateur optique RO1 (ou RO2) à l'électrode enterrée associée EL1 (ou EL2).

L'étape 300 de réalisation et de connexion du résonateur optique RO1 (et respectivement RO2) comprend une succession de sous-étapes compatibles avec un procédé de type « CMOS ».

La première sous-étape 301 de gravure des trous IH est similaire à celle du procédé P1 et P2 décrite précédemment.

La deuxième sous-étape 302 de passivation interne des vias V1 est similaire à celle du procédé P1 et P2 décrite précédemment.

La troisième sous-étape 306 consiste à graver sélectivement la couche d'arrêt de gravure CAG (pouvant être appelée aussi couche d'arrêt de polissage) pour réaliser un anneau d'arrêt de gravure AG (ou anneau d'arrêt de polissage) entourant l'accès de chacun des trous d'interconnexions IH et une cavité ENC_CAV1 autour dudit anneau d'arrêt de gravure AG servant à accueillir la couche métallique supérieure M1.

La quatrième sous-étape 303 consiste à déposer un matériau conducteur pour remplir le trou d'interconnexion IH du matériau conducteur et pour réaliser le via métallique V1 connectant électriquement ladite couche métallique supérieure M1 à l'électrode enterrée EL1 (ou EL2). De plus, la sous-étape 303 consiste à déposer un matériau conducteur pour remplir la cavité ENC_CAV1 autour de l'anneau d'arrêt de gravure AG permettant de réaliser une couche métallique supérieure M1.

La cinquième sous-étape 305 de dépôt d'une couche d'encapsulation en matériau diélectrique est similaire à la sous-étape 305 décrite pour le procédé P2.

La sixième sous-étape 305' consiste à graver sélectivement la couche d'encapsulation ENC pour découvrir l'accès du via V1.

La septième étape 307 consiste à déposer une couche de matériau conducteur sur le via V1 de manière à connecter le via V1 à la couche métallique supérieure M1 entourant l'anneau d'arrêt de gravure AG réalisé pendant la quatrième sous-étape 303.

La huitième sous-étape 305 de dépôt d'une couche d'encapsulation en matériau diélectrique est similaire à la sous-étape décrite pour le procédé P2.

La neuvième sous-étape 305' de gravure de la couche d'encapsulation ENC est similaire à la sous-étape 305' décrite pour le procédé P2.

La dixième sous-étape 304 consiste à graver sélectivement la couche du premier matériau semi-conducteur SC1 pour réaliser pour chaque résonateur une structure photo-détectrice PD d'une façon similaire aux procédés P1 et P2.

Ainsi, l'architecture de pixels selon l'invention basés sur les résonateurs optiques intégrés avec des circuits de lecture décrite précédemment présente une nouvelle solution pour la réalisation des capteurs d'images matriciels présentant les avantages techniques suivants :
o une architecture de matrice de pixels compacte permettant l'obtention d'une haute résolution ;
o un système global à volume réduit par rapport aux imageurs de l'état de l'art grâce à l'assemblage direct entre partie optique et partie électrique ;
o une performance optique améliorée mettant en œuvre les avantages des résonateurs optiques ;
o une réduction du bruit d'obscurité grâce à la limitation de la surface des zones photo-détectrices en matériaux semi-conducteurs ;
o la réduction des phénomènes de diaphonies entre les pixels puisque chaque pixel correspond à un résonateur optique singulier.

En guise de conclusion, l'invention décrite permet de réaliser l'hybridation d'un système optoélectronique ayant au moins un pixel comprenant un résonateur optique de type MIM. La pixellisation et l'interconnexion d'un pixel est réalisée au moyen d'un via de connexion traversant la structure du résonateur optique pour le connecter à l'électrode de lecture enterrée appartenant au circuit de lecture ROIC. Plusieurs modes de réalisation de la structure d'un pixel selon l'invention ont été décrits à titre indicatif sans perte de généralité. L'invention décrite permet en outre de réaliser un procédé de fabrication pour chaque mode de réalisation. Le premier procédé P1 est compatible avec une ligne de production de type « procédé III-V ». Le deuxième procédé P2 et le troisième procédé P3 sont compatibles avec une ligne de production de type « procédé CMOS ».

## Revendications

1. Dispositif optoélectronique (OPT) comprenant :
▪ au moins un pixel (Pxl), chaque pixel comprenant
o un résonateur optique (RO) comprenant une structure photo-détectrice (PD) confinée entre une première couche métallique, (M1) et une seconde couche métallique réflectrice (M2) ;
▪ et un circuit intégré de lecture (ROIC) disposé sur un substrat (Sub2) ;
le dispositif optoélectronique étant **caractérisé en ce que** le circuit intégré de lecture comprend au moins une électrode de lecture (EL) enterrée dédiée au pixel (Pxl) et au moins une couche externe métallique ou diélectrique (M3, D2) ;
l'ensemble comprenant au moins la seconde couche métallique réflectrice (M2) et la couche externe (M3,D2) du circuit intégré de lecture étant dénommé structure planaire d'assemblage (SPA) ;
la première couche métallique (M1) étant connectée à l'électrode de lecture (EL) au moyen d'un via métallique (V1) traversant la structure du résonateur optique (RO) et la structure planaire d'assemblage (SPA);
le via métallique (V1) étant électriquement isolé de la structure photo-détectrice (PD) et de la structure planaire d'assemblage (SPA).

2. Dispositif optoélectronique (OPT) selon la revendication 1 dans lequel le via métallique (V1) comporte une couche de passivation interne (PI) de matériau diélectrique déposée sur ses parois internes pour l'isoler électriquement de la seconde couche métallique réflectrice (M2) et de la structure planaire d'assemblage (SPA).

3. Dispositif optoélectronique (OPT) selon la revendication 2 dans lequel le via métallique (V1) a un diamètre inférieur à la longueur d'onde absorbée par le résonateur optique (RO) divisée par le triple de l'indice de réfraction effectif de la structure photo-détectrice (PD).

4. Dispositif optoélectronique (OPT) selon l'une quelconque des revendications précédentes dans lequel la couche métallique réflectrice (M2) est commune à tous les pixels (Pxl).

5. Dispositif optoélectronique (OPT) selon l'une quelconque des revendications précédentes dans lequel la structure planaire d'assemblage (SPA) comprend la seconde couche métallique réflectrice (M2), une troisième couche métallique (M3) connectée à la masse électrique appartenant au circuit intégré de lecture (ROIC) et une couche de passivation en matériau diélectrique appartenant au circuit intégré de lecture (ROIC).

6. Dispositif optoélectronique (OPT) selon l'une quelconque des revendications précédentes dans lequel au moins une dimension d'un résonateur (RO), choisie parmi largeur, longueur, est comprise dans l'intervalle [λ/2n - 50% ; λ/2n + 50%] avec :
λ longueur d'onde incidente
n indice de réfraction effectif de la structure photo détectrice.

7. Dispositif optoélectronique (OPT) selon l'une quelconque des revendications précédentes dans lequel la hauteur de la structure photo-détectrice (PD) est comprise dans l'intervalle [λ/4n - 50% ; λ/2n + 50%] avec :
λ longueur d'onde incidente
n indice de réfraction effectif de la structure photo détectrice.

8. Dispositif optoélectronique (OPT) selon l'une quelconque des revendications précédentes dans lequel la première couche métallique (M1) couvre la totalité de la surface (20A) de la mésa photo-détectrice (PD).

9. Dispositif optoélectronique (OPT) selon l'une quelconque des revendications 1 à 7 dans lequel la première couche métallique (M1) couvre une partie de la surface (20A) de la structure photo-détectrice (PD) ; la première couche métallique (M1) étant intégralement couverte par une couche d'encapsulation en matériau diélectrique (ENC).

10. Dispositif optoélectronique (OPT) selon la revendication 9 dans lequel l'entrée du via métallique (V1) est entourée par un anneau d'arrêt de gravure (AG) en un matériau diélectrique.

11. Dispositif optoélectronique (OPT) selon l'une quelconque des revendications précédentes dans lequel la distance entre deux pixels (Pxl) adjacents est supérieure ou égale à la longueur d'onde absorbée par le résonateur optique (RO) divisée par le double de l'indice de réfraction effectif de la structure photo-détectrice (PD).

12. Capteur d'image matriciel comprenant un dispositif optoélectronique selon l'une quelconque des revendications précédentes.

13. Procédé de fabrication d'un dispositif optoélectronique (OPT), le procédé comprenant les étapes consistant à :
- assembler (100) d'une part une première structure planaire (S1) comprenant un premier substrat (Sub1), un ensemble d'au moins une couche photo-détectrice (SC1) et une couche métallique réflectrice (M2) ;
et d'autre part un circuit intégré de lecture (ROIC) déposé sur un deuxième substrat (Sub2) et comprenant au moins une électrode de lecture enterrée (EL1, EL2)) et une couche externe (M3) métallique ou diélectrique ;
l'ensemble comprenant au moins la couche métallique réflectrice (M2) et la couche externe (M3,D2) du circuit intégré de lecture (ROIC) étant dénommé structure planaire d'assemblage (SPA) ;
- détacher (200) le premier substrat (Sub1) ;
- pour chaque électrode enterrée (EL1, EL2) : réaliser (300) un résonateur optique (RO) et connecter ledit résonateur optique (RO) à l'électrode enterrée associée (EL1, EL2) au moyen d'un via métallique (V1) traversant la structure du résonateur optique (RO) et la structure planaire d'assemblage (SPA); l'étape de réalisation et de connexion du résonateur optique (RO) étant réalisée en :
o gravant (301) un trou d'interconnexion (IH) traversant ledit ensemble d'au moins une couche photo-détectrice jusqu'à l'électrode enterrée (EL1, EL2) ;
o réalisant (302) une couche de passivation (PI) en diélectrique déposée sur les parois internes du trou d'interconnexion (IH) ;
o déposant (303) un matériau conducteur sur une surface externe dudit ensemble d'au moins une couche photo-détectrice (SC1), centrée sur le trou d'interconnexion (IH) pour réaliser une première couche métallique (M1) ;
o déposant (303) le matériau conducteur pour remplir le trou d'interconnexion (IH) du matériau conducteur et pour réaliser le via métallique (V1) connectant électriquement ladite première couche métallique (M1) à l'électrode enterrée (EL1, EL2).
∘ gravant (304) sélectivement chacune des couches dudit ensemble d'au moins une couche photo-détectrice pour réaliser une structure photo-détectrice (SC1) du résonateur optique (RO) ; la structure photo-détectrice (SC1) étant confinée entre la couche métallique réflectrice (M2) et ladite première couche métallique (M1).

14. Procédé de fabrication d'un dispositif optoélectronique (OPT) selon la revendication 13 dans lequel l'étape de réalisation (300) et de connexion d'un résonateur optique (RO) à l'électrode enterrée associée (EL1, EL2) comprend en outre les sous-étapes suivantes :
- déposer (305) une couche d'encapsulation en matériau diélectrique (ENC) couvrant la première couche métallique (M1).
- graver sélectivement (305') la couche d'encapsulation (ENC) pour garder au moins les parties couvrant la première couche métallique (M1).

15. Procédé de fabrication d'un dispositif optoélectronique (OPT) selon la revendication 14 comprenant :
- une étape de dépôt (400) d'une couche d'arrêt de gravure (CAG) sur une couche externe dudit ensemble d'au moins une couche photo-détectrice (SC1)préalable à l'étape de réalisation et de connexion (300) d'un résonateur optique (RO) à l'électrode enterrée associée (EL1, EL2),
- et dans lequel l'étape de réalisation et de connexion (300) d'un résonateur optique (RO) à l'électrode enterrée associée (EL1, EL2) comprend en outre les sous-étapes suivantes :
- graver sélectivement (306) la couche d'arrêt de gravure (CAG) pour réaliser un anneau d'arrêt de gravure (AG) entourant l'accès au trou d'interconnexion (IH) et une cavité (ENC_CAV1) autour dudit anneau d'arrêt de gravure (AG) servant à accueillir une partie de la première couche métallique (M1),
- déposer (307) une couche de matériau conducteur sur le via de manière à le connecter à la première couche métallique (M1).

16. Procédé de fabrication d'un dispositif optoélectronique (OPT) selon la revendication 13 dans lequel le matériau conducteur déposé pour la réalisation de la première couche métallique (M1) et du via métallique (V1) est l'or ou l'argent ou le platine.

17. Procédé de fabrication d'un dispositif optoélectronique (OPT) selon l'une des revendications 14 ou 15 dans lequel le matériau conducteur déposé pour la réalisation de la première couche métallique (M1) et du via métallique (V1) est le cuivre ou l'aluminium ou le tungstène.

18. Procédé selon l'une des revendications 13 à 17 dans lequel l'étape de réalisation simultanée des trous d'interconnexion (IH) et des résonateurs (RO) s'effectue par lithographie puis gravure, la technologie de lithographie étant choisie parmi : par faisceau d'électrons ; par nano-impression ; par lithographie optique, et la technologie de gravure étant choisie parmi la gravure ionique, gravure chimique ou plasma.

## Patentansprüche

1. Optoelektronische Vorrichtung (OPT), Folgendes umfassend:
▪ mindestens ein Pixel (Pxl), wobei jedes Pixel Folgendes umfasst
o einen optischen Resonator (RO), umfassend eine Fotodetektorstruktur (PD), die zwischen einer ersten Metallschicht (M1) und einer zweiten reflektierenden Metallschicht (M2) eingeschlossen ist;
▪ und eine integrierte Ausleseschaltung (ROIC), die auf einem Substrat (Sub2) angeordnet ist;
wobei die optoelektronische Vorrichtung **dadurch gekennzeichnet ist, dass** die integrierte Ausleseschaltung mindestens eine vergrabene Ausleseelektrode (EL), die für das Pixel (Pxl) dediziert ist, und mindestens eine Metall- oder dielektrische Außenschicht (M3, D2) umfasst;
wobei die Anordnung mindestens die zweite reflektierende Metallschicht (M2) umfasst und die Außenschicht (M3, D2) der integrierten Ausleseschaltung als planare Anordnungsstruktur (SPA) bezeichnet wird;
wobei die erste Metallschicht (M1) mit der Ausleseelektrode (EL) mittels eines Metalldurchgangs (V1) verbunden ist, der durch die Struktur des optischen Resonators (RO) und die planare Anordnungsstruktur (SPA) hindurchgeht;
wobei der Metalldurchgang (V1) elektrisch von der Fotodetektorstruktur (PD) und von der planaren Anordnungsstruktur (SPA) isoliert ist.

2. Optoelektronische Vorrichtung (OPT) nach Anspruch 1, wobei der Metalldurchgang (V1) eine interne Passivierungsschicht (PI) aus dielektrischem Material aufweist, die auf seinen Innenwänden abgelagert ist, um ihn elektrisch von der zweiten reflektierenden Metallschicht (M2) und von der planaren Anordnungsstruktur (SPA) zu isolieren.

3. Optoelektronische Vorrichtung (OPT) nach Anspruch 2, wobei der Metalldurchgang (V1) einen Durchmesser aufweist, der kleiner als die von dem optischen Resonator (RO) absorbierte Wellenlänge geteilt durch das Dreifache des effektiven Brechungsindexes der Fotodetektorstruktur (PD) ist.

4. Optoelektronische Vorrichtung (OPT) nach einem der vorhergehenden Ansprüche, wobei die reflektierende Metallschicht (M2) allen Pixeln (Pxl) gemeinsam ist.

5. Optoelektronische Vorrichtung (OPT) nach einem der vorhergehenden Ansprüche, wobei die planare Anordnungsstruktur (SPA) die zweite reflektierende Metallschicht (M2), eine dritte Metallschicht (M3), die mit der elektrischen Masse verbunden ist, die zu der integrierten Ausleseschaltung (ROIC) gehört, und eine Passivierungsschicht aus dielektrischem Material umfasst, die zu der integrierten Ausleseschaltung (ROIC) gehört.

6. Optoelektronische Vorrichtung (OPT) nach einem der vorhergehenden Ansprüche, wobei mindestens eine Abmessung eines Resonators (RO), ausgewählt aus Breite und Länge, innerhalb des Intervalls [λ/2n - 50 %; λ/2n + 50 %] liegt, worin:
λ eine einfallende Wellenlänge ist;
n ein effektiver Brechungsindex der Fotodetektorstruktur ist.

7. Optoelektronische Vorrichtung (OPT) nach einem der vorhergehenden Ansprüche, wobei die Höhe der Fotodetektorstruktur (PD) innerhalb des Intervalls [λ/4n - 50 %; λ/2n + 50 %] liegt, worin:
λ eine einfallende Wellenlänge ist;
n ein effektiver Brechungsindex der Fotodetektorstruktur ist.

8. Optoelektronische Vorrichtung (OPT) nach einem der vorhergehenden Ansprüche, wobei die erste Metallschicht (M1) die gesamte Oberfläche (20A) der Fotodetektormesa (PD) bedeckt.

9. Optoelektronische Vorrichtung (OPT) nach einem der Ansprüche 1 bis 7, wobei die erste Metallschicht (M1) einen Teil der Oberfläche (20A) der Fotodetektorstruktur (PD) bedeckt; wobei die erste Metallschicht (M1) vollständig von einer Einkapselungsschicht aus einem dielektrischen Material (ENC) bedeckt ist.

10. Optoelektronische Vorrichtung (OPT) nach Anspruch 9, wobei der Eingang des Metalldurchgangs (V1) von einem Ätzstoppring (AG) aus einem dielektrischen Material umgeben ist.

11. Optoelektronische Vorrichtung (OPT) nach einem der vorhergehenden Ansprüche, wobei der Abstand zwischen zwei angrenzenden Pixeln (Pxl) größer als die oder gleich der von dem optischen Resonator (RO) absorbierten Wellenlänge geteilt durch das Doppelte des effektiven Brechungsindexes der Fotodetektorstruktur (PD) ist.

12. Matrixbildsensor, umfassend eine optoelektronische Vorrichtung nach einem der vorhergehenden Ansprüche.

13. Verfahren zum Herstellen einer optoelektronischen Vorrichtung (OPT), wobei das Verfahren folgende Schritte umfasst:
- Zusammenbauen (100) einerseits einer ersten planaren Struktur (S1), umfassend ein erstes Substrat (Sub1), eine Anordnung von mindestens einer Fotodetektorschicht (SC1) und einer reflektierenden Metallschicht (M2);
und andererseits einer integrierten Ausleseschaltung (ROIC), die auf einem zweiten Substrat (Sub2) abgelagert ist und mindestens eine vergrabene Ausleseelektrode (EL1, EL2) und eine Metall- oder dielektrische Außenschicht (M3) umfasst;
wobei die Anordnung mindestens die zweite reflektierende Metallschicht (M2) umfasst und die Außenschicht (M3, D2) der integrierten Ausleseschaltung (ROIC) als planare Anordnungsstruktur (SPA) bezeichnet wird;
- Ablösen (200) des ersten Substrats (Sub1);
- für jede vergrabene Elektrode (EL1, EL2): Fertigen (300) eines optischen Resonators (RO) und Verbinden des optischen Resonators (RO) mit der zugeordneten vergrabenen Elektrode (EL1, EL2) mittels eines Metalldurchgangs (V1), der durch die Struktur des optischen Resonators (RO) und die planare Anordnungsstruktur (SPA) hindurchgeht; wobei der Schritt des Fertigens und Verbindens des optischen Resonators (RO) ausgeführt wird durch Folgendes:
o Ätzen (301) eines Durchschaltungslochs (IH), das durch die Anordnung aus mindestens einer Fotodetektorschicht bis zu der vergrabenen Elektrode (EL1, EL2) hindurchgeht;
o Fertigen (302) einer Passivierungsschicht (PI) aus dielektrischem Material, die auf den Innenwänden des Durchschaltungslochs (IH) abgelagert ist;
o Ablagern (303) eines leitfähigen Materials auf einer Außenfläche der Anordnung aus mindestens einer Fotodetektorschicht (SC1) zentriert auf dem Durchschaltungsloch (IH), um eine erste Metallschicht (M1) zu fertigen,
o Ablagern (303) des leitfähigen Materials, um das Durchschaltungsloch (IH) mit dem leitfähigen Material zu füllen und um den Metalldurchgang (V1) zu fertigen, der die erste Metallschicht (M1) mit der vergrabenen Elektrode (EL1, EL2) elektrisch verbindet;
o selektives Ätzen (304) jeder der Schichten der Anordnung von mindestens einer Fotodetektorschicht, um eine Fotodetektorstruktur (SC1) des optischen Resonators (RO) zu fertigen; wobei die Fotodetektorstruktur (SC1) zwischen der reflektierenden Metallschicht (M2) und der ersten Metallschicht (M1) eingeschlossen ist.

14. Verfahren zum Herstellen einer optoelektronischen Vorrichtung (OPT) nach Anspruch 13, wobei der Schritt des Fertigens (300) und Verbindens eines optischen Resonators (RO) mit der zugeordneten vergrabenen Elektrode (EL1, EL2) ferner die folgenden Unterschritte umfasst:
- Ablagern (305) einer Einkapselungsschicht aus dielektrischem Material (ENC), die die erste Metallschicht (M1) bedeckt.
- selektives Ätzen (305') der Einkapselungsschicht (ENC), um mindestens die Teile, die die erste Metallschicht (M1) bedecken, zu behalten.

15. Verfahren zum Herstellen einer optoelektronischen Vorrichtung (OPT) nach Anspruch 14, Folgendes umfassend:
- einen Schritt zum Ablagern (400) einer Ätzstoppschicht (CAG) auf einer Außenschicht der Anordnung von mindestens einer Fotodetektorschicht (SC1) vor dem Schritt des Fertigens und Verbindens (300) eines optischen Resonators (RO) mit der zugeordneten vergrabenen Elektrode (EL1, EL2),
- und wobei der Schritt des Fertigens und Verbindens (300) eines optischen Resonators (RO) mit der zugeordneten vergrabenen Elektrode (EL1, EL2) ferner die folgenden Unterschritte umfasst:
- selektives Ätzen (306) der Ätzstoppschicht (CAG), um einen Ätzstoppring (AG), der den Zugang zu dem Durchschaltungsloch (IH) umgibt, und einen Hohlraum (ENC_CAV1) um den Ätzstoppring (AG) zu fertigen, der dazu dient, einen Teil der ersten Metallschicht (M1) aufzunehmen,
- Ablagern (307) einer Schicht aus leitfähigem Material auf dem Durchgang, sodass sie mit der ersten Metallschicht (M1) verbunden wird.

16. Verfahren zum Herstellen einer optoelektronischen Vorrichtung (OPT) nach Anspruch 13, wobei das leitfähige Material, das zum Fertigen der ersten Metallschicht (M1) und des Metalldurchgangs (V1) abgelagert ist, Gold oder Silber oder Platin ist.

17. Verfahren zum Herstellen einer optoelektronischen Vorrichtung (OPT) nach einem der Ansprüche 14 oder 15, wobei das leitfähige Material, das zum Fertigen der ersten Metallschicht (M1) und des Metalldurchgangs (V1) abgelagert ist, Kupfer oder Aluminium oder Wolfram ist.

18. Verfahren nach einem der Ansprüche 13 bis 17, wobei der Schritt des gleichzeitigen Fertigens der Durchschaltungslöcher (IH) und der Resonatoren (RO) durch Lithographie und anschließendes Ätzen ausgeführt wird, wobei die Lithographietechnologie aus Folgenden ausgewählt wird: durch Elektronenstrahl; durch Nanodrucken; durch optische Lithographie, und wobei die Ätztechnologie aus Ionenätzen, chemischem Ätzen oder Plasma ausgewählt wird.

## Claims

1. An optoelectronic device (OPT) comprising:
▪ at least one pixel (Pxl), each pixel comprising
∘ an optical resonator (RO) comprising a photodetecting structure (PD) confined between a first metal layer (M1) and a second reflective metal layer (M2);
▪ and a readout integrated circuit (ROIC) arranged on a substrate (Sub2);
the optoelectronic device being **characterised in that** the readout integrated circuit comprises at least one buried readout electrode (EL) dedicated to the pixel (Pxl) and at least one metal or dielectric outer layer (M3, D2);
the assembly comprising at least the second reflective metal layer (M2) and the outer layer (M3, D2) of the readout integrated circuit being referred to as planar assembly structure (SPA);
the first metal layer (M1) being connected to the readout electrode (EL) by way of a metal via (V1) passing through the optical resonator (RO) structure and the planar assembly structure (SPA);
the metal via (V1) being electrically isolated from the photodetecting structure (PD) and from the planar assembly structure (SPA).

2. The optoelectronic device (OPT) according to claim 1, wherein the metal via (V1) contains a dielectric material internal passivation layer (PI) deposited on its internal walls so as to electrically isolate it from the second reflective metal layer (M2) and from the planar assembly structure (SPA).

3. The optoelectronic device (OPT) according to claim 2, wherein the metal via (V1) has a diameter smaller than the wavelength absorbed by the optical resonator (RO) divided by three times the effective refractive index of the photodetecting structure (PD).

4. The optoelectronic device (OPT) according to any one of the preceding claims, wherein the reflective metal layer (M2) is common to all of the pixels (Pxl).

5. The optoelectronic device (OPT) according to any one of the preceding claims, wherein the planar assembly structure (SPA) comprises the second reflective metal layer (M2), a third metal layer (M3) connected to electrical ground belonging to the readout integrated circuit (ROIC) and a passivation layer made of dielectric material belonging to the readout integrated circuit (ROIC).

6. The optoelectronic device (OPT) according to any one of the preceding claims, wherein at least one dimension of a resonator (RO), chosen from among width and length, is within the interval [λ/2n - 50%; λ/2n + 50%], where:
λ is an incident wavelength;
n is an effective refractive index of the photodetecting structure.

7. The optoelectronic device (OPT) according to any one of the preceding claims, wherein the height of the photodetecting structure (PD) is within the interval [λ/4n - 50%; λ/2n + 50%], where:
λ is an incident wavelength;
n is an effective refractive index of the photodetecting structure.

8. The optoelectronic device (OPT) according to any one of the preceding claims, wherein the first metal layer (M1) covers the entire surface (20A) of the photodetecting mesa (PD).

9. The optoelectronic device (OPT) according to any one of claims 1 to 7, wherein the first metal layer (M1) covers part of the surface (20A) of the photodetecting structure (PD); the first metal layer (M1) being fully covered by an encapsulating layer made of dielectric material (ENC).

10. The optoelectronic device (OPT) according to claim 9, wherein the inlet of the metal via (V1) is surrounded by an etch stop ring (AG) made of a dielectric material.

11. The optoelectronic device (OPT) according to any one of the preceding claims, wherein the distance between two adjacent pixels (Pxl) is greater than or equal to the wavelength absorbed by the optical resonator (RO) divided by twice the effective refractive index of the photodetecting structure (PD).

12. A matrix image sensor comprising an optoelectronic device according to any one of the preceding claims.

13. A method for manufacturing an optoelectronic device (OPT), the method comprising the steps of:
- assembling (100) a first planar structure (S1) comprising a first substrate (Sub1), an assembly of at least one photodetecting layer (SC1) and a reflective metal layer (M2), on the one hand;
and a readout integrated circuit (ROIC) deposited on a second substrate (Sub2) and comprising at least one buried readout electrode (EL1, EL2) and a metal or dielectric outer layer (M3), on the other hand;
the assembly comprising at least the reflective metal layer (M2) and the outer layer (M3, D2) of the readout integrated circuit (ROIC) being referred to as planar assembly structure (SPA);
- detaching (200) the first substrate (Sub1);
- for each buried electrode (EL1, EL2): producing (300) an optical resonator (RO) and connecting said optical resonator (RO) to the associated buried electrode (EL1, EL2) by way of a metal via (V1) passing through the structure of the optical resonator (RO) and the planar assembly structure (SPA); the step of producing and connecting the optical resonator (RO) being carried out by:
∘ etching (301) a via hole (IH) passing through said assembly of at least one photodetecting layer to the buried electrode (EL1, EL2);
∘ producing (302) a passivation layer (PI) made of dielectric material, deposited on the internal walls of the via hole (IH);
∘ depositing (303) a conductive material on an outer surface of said assembly of at least one photodetecting layer (SC1), centred on the via hole (IH), to produce a first metal layer (M1),
∘ depositing (303) the conductive material to fill the via hole (IH) with the conductive material and to produce the metal via (V1) electrically connecting said first metal layer (M1) to the buried electrode (EL1, EL2);
∘ selectively etching (304) each of the layers of said assembly of at least one photodetecting layer to produce a photodetecting structure (SC1) of the optical resonator (RO); the photodetecting structure (SC1) being confined between the reflective metal layer (M2) and said first metal layer (M1).

14. The method for manufacturing an optoelectronic device (OPT) according to claim 13, wherein the step of producing (300) and connecting an optical resonator (RO) to the associated buried electrode (EL1, EL2) further comprises the following sub-steps:
- depositing (305) an encapsulating layer made of dielectric material (ENC) covering the first metal layer (M1).
- selectively etching (305') the encapsulating layer (ENC) to keep at least the parts covering the first metal layer (M1).

15. The method for manufacturing an optoelectronic device (OPT) according to claim 14, comprising:
- a step of depositing (400) an etch stop layer (CAG) on an outer layer of said assembly of at least one photodetecting layer (SC1) prior to the step of producing and connecting (300) an optical resonator (RO) to the associated buried electrode (EL1, EL2),
- and wherein the step of producing and connecting (300) an optical resonator (RO) to the associated buried electrode (EL1, EL2) further comprises the following sub-steps:
- selectively etching (306) the etch stop layer (CAG) to produce an etch stop ring (AG) surrounding the access to the via hole (IH) and a cavity (ENC_CAV1) around said etch stop ring (AG) that serves to receive part of the first metal layer (M1),
- depositing (307) a layer of conductive material on the via to connect it to the first metal layer (M1).

16. The method for manufacturing an optoelectronic device (OPT) according to claim 13, wherein the conductive material deposited to produce the first metal layer (M1) and the metal via (V1) is gold or silver or platinum.

17. The method for manufacturing an optoelectronic device (OPT) according to any one of claim 14 or 15, wherein the conductive material deposited to produce the first metal layer (M1) and the metal via (V1) is copper or aluminium or tungsten.

18. The method according to one of claims 13 to 17, wherein the step of simultaneously producing the via holes (IH) and the resonators (RO) is carried out by lithography then etching, the lithography technology being chosen from among: electron beam; nanoprinting; optical lithography, and the etching technology being chosen among ion etching, chemical etching or plasma.
